(19) Europäisches Patentamt
European Patent Office
Office européen des brevets

(11) **EP 0 809 125 B1**

(12) **EUROPÄISCHE PATENTSCHRIFT**

(45) Veröffentlichungstag und Bekanntmachung des Hinweises auf die Patenterteilung:
**02.02.2005   Patentblatt 2005/05**

(51) Int Cl.⁷: **G02B 6/38**, G03F 7/20, G02B 17/08

(21) Anmeldenummer: **97106031.4**

(22) Anmeldetag: **12.04.1997**

(54) **Hochauflösendes lichtstarkes Objektiv**

Fast high resolution lens

Objectif lumineux à haute résolution

(84) Benannte Vertragsstaaten:
**DE NL**

(30) Priorität: **27.04.1996   DE 19616922**

(43) Veröffentlichungstag der Anmeldung:
**26.11.1997   Patentblatt 1997/48**

(73) Patentinhaber: **Carl Zeiss SMT AG**
**73447 Oberkochen (DE)**

(72) Erfinder: **Fürter, Gerd**
**73479 Ellwangen (DE)**

(74) Vertreter:
**Müller-Rissmann, Werner Albrecht, Dr. et al**
**Carl Zeiss,**
**Patentabteilung**
**73446 Oberkochen (DE)**

(56) Entgegenhaltungen:
**EP-A- 0 350 955          EP-A- 0 465 882**
**DE-A- 4 110 296          DE-A- 4 203 464**
**US-A- 5 212 593**

**Beschreibung**

Die Erfindung betrifft ein hochauflösendes lichtstarkes Objektiv, ausgeführt als katadioptrisches Reduktionsobjektiv mit Linsengruppen, Strahlteiler und Konkavspiegel nach dem Oberbegriff des Anspruches 1.

Derartige Objektive sind als Projektionsobjektiv für die Mikrolithographie mit Strahlung im tiefen UV-Bereich (Wellenlängen 248 nm, 193 nm u.a.) bekannt, z.B. aus US 5,402,226 A und aus DE 44 17 489 A. Bei den genannten Schutzrechten ist die Anmelderin die gleiche wie bei dieser Patentanmeldung und der Erfinder ist zumindest Miterfinder. Der Inhalt dieser Schriften soll Teil dieser Offenbarung sein.

Aus der US 5,212,593 A ist ein katadioptrisches Reduktionsobjektiv mit Strahlteilerwürfel bekannt, bei dem der Sinus des Randstrahlwinkels unmittelbar vor dem Strahlteilerwürfel gegenüber dem am Reticle stark reduziert ist. Dies erfordert jedoch einen verhältnismäßig großen Strahlteilerwürfel. Die Möglichkeit, einen solchen Strahlverlauf in der zweiten Linsengruppe zur Farbkorrektur zu nutzen, wird nicht erkannt. Stattdessen werden zur Farbkorrektur zwei unterschiedliche Materialen verwendet.

Bei der EP 0 465 882 A stellt das hier in Frage kommende Beispiel der Figur 2 und Tabelle 1 keine nachvollziehbare Offenbarung dar, da Zeichnung und Tabelle offensichtliche Unterschiede aufweisen und die Daten der Tabelle kein funktionsfähiges Objektiv ergeben.

Bei der US 5,251,070 A (Figur 4) ist die numerische Apertur mit 0,4 weitaus geringer als erfindungsgemäß vorgesehen, damit sind die Anforderungen an das Objektiv insgesamt entspannt. Der Randstrahlwinkel nimmt vom Objekt - dem Reticle - zum Strahlteiler und Spiegel zu.

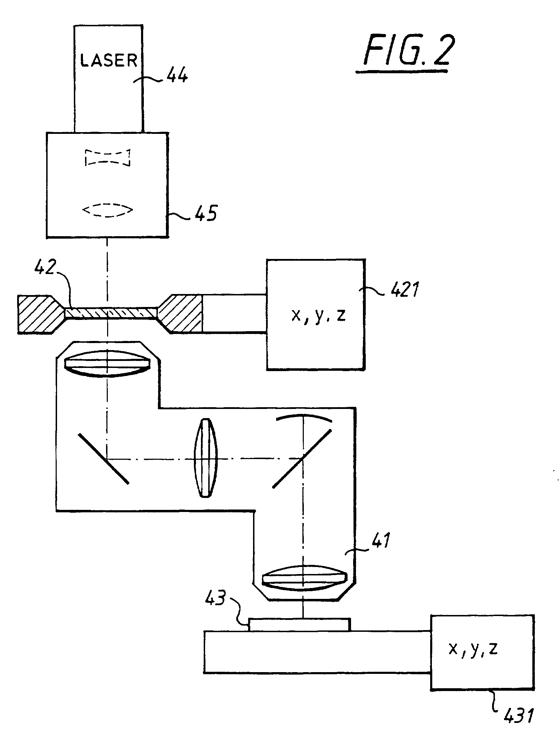

Bei US 5,402,226 A ist ein wesentlich verkleinernder Abbildungsmaßstab des Hohlspiegels kleiner als 0,3, im Ausführungsbeispiel 0,14, beim vierfach verkleinernden Objektiv vorgesehen. Beim Ausführungsbeispiel nach Figur 2 oder 3 und Tabelle 2 mit der numerischen Apertur von 0,58 ist der Sinus des Randstrahlwinkels am Reticle 0,145, nach der ersten Linsergruppe, am (möglichen) Ort des Faltspiegels ca. 0,13 und nach der zweiten Linsengruppe, also am Eingang des Strahlteilers 0,060.

Bei EP 0 608 572 A ist (vgl. claims 1, 2, 25, 27) vorgesehen, daß die jeweils dem Strahlteilerwürfel und dem Konkavspiegel vorangehende Linsengruppe "negative power" in dem Sinne hat, daß die - lokale - numerische Apertur, gleichbedeutend mit dem Sinus des Randstrahlwinkels, erhöht wird. Die vorgelagerten Linsengruppen sind gerade so ausgelegt, daß sie die Eintrittspupille vom Unendlichen in die Systemblende am Konkavspiegel abbilden. Unter anderem kann durch diese Maßnahmen der Büschelquerschnitt am Strahlteilereingang klein gehalten werden. Dadurch gelangt man zu einem vorteilhaft kleinen Strahlteilerwürfel auch bei großer numerischer Apertur (0,7) des Objektivs.

Aufgabe der Erfindung ist die Bereitstellung eines gattungsgemäßen katadioptrischen Reduktionsobjektivs, bei dem am Eintritt in den Strahlteiler der Randstrahlwinkel und der Büscheldurchmesser, welche in gegenseitiger Abhängigkeit stehen, besonders vorteilhaft sind. Dabei ermöglicht einerseits ein kleiner Büscheldurchmesser einen spezifisch kleinen Strahlteiler, wodurch hohe numerische Apertur ermöglicht wird: Zunächst wird vom Strahlteiler der Raum für die Unterbringung von Linsen nicht zu sehr beeinträchtigt (vgl. US 5,402,267), weiter wird die Herstellung eines störungsfreien Strahlteilers mit schrumpfenden Abmessungen wesentlich erleichtert.

Der andererseits begrenzt bleibende Divergenzwinkel ist eine bedeutende Erleichterung für die Herstellung eines hochwertigen Polarisationsstrahlteilers aus dielektrischen Schichten.

Gleichzeitig soll eine hervorragende Farbkorrektion auch ohne Einsatz von verschiedenen Linsenmaterialien erzielt werden.

Die Aufgabe wird gelöst durch ein gattungsgemäßes Objektiv mit den kennzeichnenden Merkmalen des Anspruches 1, wonach die erste und zweite Linsengruppe insgesamt den Sinus des Randstrahlwinkels reduzieren, und zwar um bis zu 40 %. Bevorzugt wird hier ein Bereich bis ca. 30 %.

Die Abbildung der im Unendlichen liegenden Eintrittspupille auf die Systemblende im Bereich des Konkavspiegels wird dadurch zwar erschwert, ist aber dennoch möglich.

Zugleich kann dadurch nicht ganz so gut wie bei EP 0 608 572 A, aber doch hinreichend, der aus zwei Prismen zusammengesetzte, etwa würfelförmige Strahlteiler klein gehalten werden. Dies gilt vor allem für die Anwendung des Objektivs in einem Wafer-Scanner, wobei das Bild ein schmaler Schlitz ist.

Wird der Randstrahlwinkel vor dem Strahlteiler insgesamt reduziert, so sind die Randstrahlhöhen vor allem in Strahlteilernähe größer, als wenn der Randstrahlwinkel erhöht wird. Außerdem sind die Brechkräfte in Strahlteilernähe größer. Dies gilt besonders, wenn die zweite Linsengruppe sammelnd, also randstrahlreduzierend, wirkt. Dadurch wird also das Produkt aus Randstrahlhöhe mal Brechkraft im Bereich vor dem Strahlteiler erhöht. Die Korrektionswirkung auf die chromatische Vergrößerungsdifferenz ist aber zu diesem Produkt proportional. Durch diese erfindungsgemäße Ausbildung wird also unabhängig davon, ob zusätzlich Achromatisierung durch zwei verschiedene Linsenmaterialien betrieben wird, eine sehr gute Farbkorrektur erreicht.

Geht die Verkleinerungswirkung über 30 % hinaus gegen 40 %, so verbessert sich zwar die Farbkorrektion weiter, der Strahlteiler wird aber noch größer, so daß eine numerische Apertur des Objektivs von 0,7 sehr erschwert wird und eher eine NA von 0,6 mit guter Qualität gemacht werden kann.

Die Unteransprüche 2 bis 6 betreffen vorteilhafte Weiterbildungen. Gemäß Anspruch 2 reduziert auch die zweite Linsengruppe den Sinus des Randstrahlwinkels um bis zu 40 %. Gewöhnlich ist die zweite Linsengruppe von der ersten durch einen Freiraum getrennt, der geeignet ist zur Anordnung eines Umlenkspiegels. Die oben beschriebene farbkorrrigierende Wirkung wird vorwiegend durch die zweite Linsengruppe bewirkt.

Nach Anspruch 3 soll die erste Linsengruppe den Randstrahlwinkel nicht reduzieren, im Gegensatz zur EP 0 608 572 A. Hier soll eher noch eine Erhöhung erfolgen, da dann die beschriebene Farbkorrekturwirkung der zweiten Linsengruppe noch verstärkt wird. Die Abbildung der im Unendlichen liegenden Eintrittspupille auf die Systemblende im Bereich des Konkavspiegels wird auch dadurch nicht beeinträchtigt.

Je weniger optische Elemente zwischen Strahlteiler und Hohlspiegel sind, desto höher kann die numerische Apertur getrieben werden. Besonders störend sind hier freistehende Linsen. Deshalb sollen nach Anspruch 4 keine freistehenden Linsen zwischen Strahlteiler und Hohlspiegel angeordnet sein. Eine Planplatte 19/20 ist aber unvermeidlich, wenn die Lambdaviertelplatte nicht als Dünnschichtpaket auf der Austrittsfläche 18 des Strahlteilers ausgebildet werden kann.

Anspruch 5 zeigt, daß das Objektiv mit nur sieben Linsen in den ersten beiden Linsengruppen vergleichsweise sparsam aufgebaut werden kann.

Anspruch 6 gibt an, daß der Strahlteiler zuerst in Reflexion benutzt wird. Damit ist für diesen kritischen Kontakt (im Vergleich zur Transmission) die geringe Divergenz der Strahlen vor der Wirkung des Konkavspiegels genutzt.

Anspruch 7 beschreibt ein komplettes Mikrolithographie-Projektionsbelichtungssystem mit einem Projektionsobjektiv entsprechend den vorhergehenden Patentansprüchen. Dieses ist für das tiefe Ultraviolett (Wellenlänge kleiner als 250 nm) ausgelegt und besonders für einen Excimer-Laser mit 193 nm Wellenlänge als Lichtquelle vorgesehen. In diesem Wellenlängenbereich benötigen nämlich bekannte rein refraktive Objektive spektral sehr schmalbandige Laser.

Näher erläutert wird die Erfindung anhand des in der Zeichnung dargestellten Ausführungsbeispiels.

Figur 1     zeigt einen Linsenschnitt eines erfindungsgemäßen katadioptrischen Reduktionsobjektivs;

Figur 2     zeigt schematisch eine Mikrolithographie-Projektionsbelichtungsanlage.

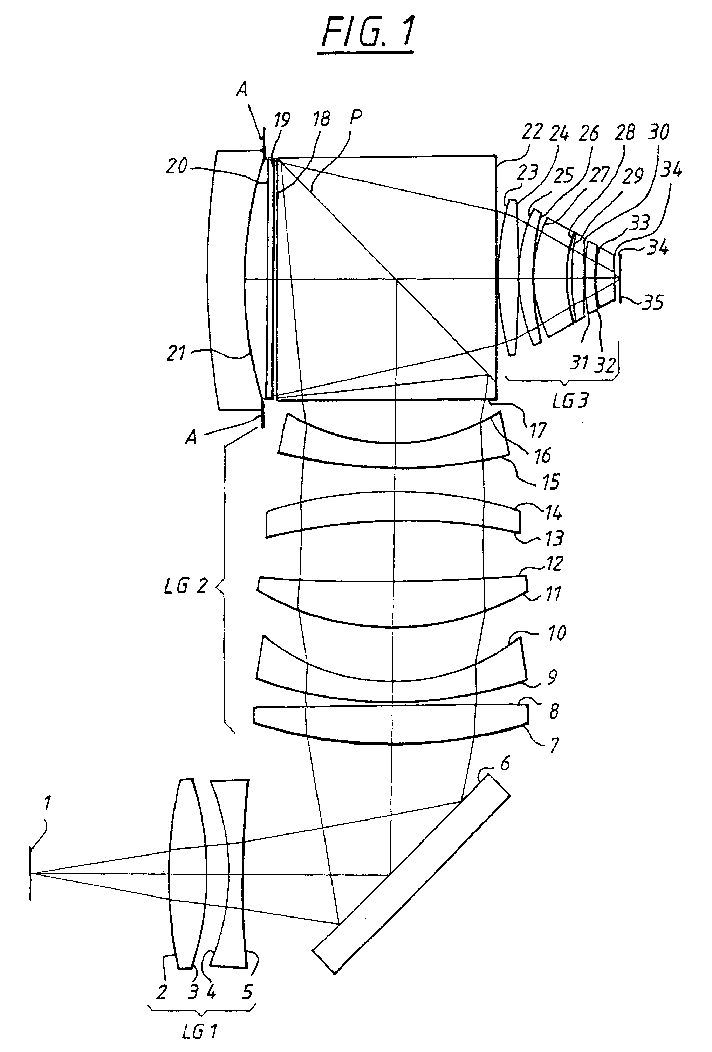

Zu dem Ausführungsbeispiel mit dem Linsenschnitt der Figur 1 gibt die Tabelle 1 die Linsendaten an. Tabelle 2 vergleicht einige wichtige Sinus des Randstrahlwinkels und Abbildungsmaßstäbe des Beispiels mit den Beispielen aus US 5,402,226 A und EP 0 608 572 A.

Tabelle 1

| Die Polarisations-Strahlteilerfläche P steht unter 45° zur Achse. | | | |
|---|---|---|---|
| Nr. | Radius | Dicke | Glasname |
| 1 | ∞ | 111,81 | |
| 2 | 571,30 | 25,84 | Quarz |
| 3 | -220,45 | 17,32 | |
| 4 | -215,16 | 12,41 | Quarz |
| 5 | 762,94 | 114,98 | |
| 6 | ∞ | 100,00 | |
| 7 | 326,54 | 30,46 | Quarz |
| 8 | -15991,4 | 1,08 | |
| 9 | 295,05 | 18,88 | Quarz |
| 10 | 166,26 | 39,75 | |
| 11 | 197,82 | 37,80 | Quarz |
| 12 | 1373,9 | 48,16 | |
| 13 | -407,42 | 23,18 | Quarz |
| 14 | -328,40 | 18,07 | |
| 15 | 420,97 | 13,36 | Quarz |
| 16 | 143,03 | 38,46 | |
| 17 | ∞ | 100,47 | Quarz |
| P | | 87,21 | Quarz |
| 18 | ∞ | 2,04 | |

Tabelle 1   (fortgesetzt)

| Die Polarisations-Strahlteilerfläche P steht unter 45° zur Achse. | | | |
|---|---|---|---|
| Nr. | Radius | Dicke | Glasname |
| 19 | $\infty$ | 5,10 | Quarz |
| 20 | $\infty$ | 15,77 | |
| 21 | -365,14 | 15,77 | |
| 20' | $\infty$ | 5,10 | Quarz |
| 19' | $\infty$ | 2,04 | |
| 18' | $\infty$ | 174,42 | Quarz |
| 22 | $\infty$ | 1,02 | |
| 23 | 219,50 | 16,42 | Quarz |
| 24 | -1096,48 | 0,76 | |
| 25 | 126,12 | 11,66 | Quarz |
| 26 | 165,00 | 0,76 | |
| 27 | 105,25 | 25,65 | Quarz |
| 28 | 85,75 | 4,38 | |
| 29 | 153,52 | 9,69 | Quarz |
| 30 | 3048,63 | ,51 | |
| 31 | 177,01 | 7,06 | Quarz |
| 32 | 98,28 | 1,29 | |
| 33 | 112,73 | 14,71 | Quarz |
| 34 | 597,26 | 4,28 | |
| 35 | $\infty$ | 0,00 | |

Der Hohlspiegel 21 ist dabei eine Asphäre nach der üblichen Formel:

$$z = \{ 1 : [ r + r \cdot \sqrt{(1 - h^2/r^2)} ]\} \cdot h^2$$

$$+ A_4 h^4 + A_6 h^6 + A_8 h^8 + A_{10} h^{10} + A_{12} h^{12}$$

mit r = Scheitelradius, h = Höhe zur optischen Achse und mit den Asphärenkonstanten

$$A_4 = 0,175861 \cdot 10^{-9}$$

$$A_6 = 0,267922 \cdot 10^{-13}$$

$$A_8 = 0,174598 \cdot 10^{-17}$$

$$A_{10} = - 0,606697 \cdot 10^{-22}$$

$$A_{12} = + 0,769485 \cdot 10^{-26}$$

Die bildseitige numerische Apertur ist 0,70, das Bildfeld ist, einem Wafer-Scanner angepaßt, 26 x 7 mm$^2$. Der Abbildungsmaßstab ist $\beta$ = -0,25.
Ausgelegt ist das Objektiv für die Wellenlänge 193 nm eines ArF-Excimer-Lasers.
Zwischen den Flächen 17 und 18 liegt diagonal die Polarisations-Strahlteilerfläche P, die das vom Reticle 1 kommende Lichtbündel reflektiert und um 90° umgelenkt zum Konkavspiegel 21 hinlenkt. Die planparallele Platte mit den Flächen 19 und 20 wird als Lambdaviertelplatte ausgebildet - beispielsweise durch dielektrische Schichten, Spannungsdoppelbrechung oder optisch zweiachsiges Material -, welche dafür sorgt, daß das vom Konkavspiegel 21 rückreflektierte Licht die Strahlteilerfläche P passieren kann zur Austrittsebene 22 des Strahlteilers.

Die Systemblende A sitzt zwischen der Lambdaviertelplatte 19/20 und dem Konkavspiegel 21. Sie kann im Raum zwischen Austrittsfläche 18 und Konkavspiegel 21 auch anderswohin gelegt werden. Mit Hilfe der Systemblende kann wahlweise die numerische Apertur variiert werden. Die Korrektion des gezeigten Objektivs ist darauf ausgerichtet, daß dadurch keine Verschlechterung eintritt.

Zwischen Strahlteiler und Konkavspiegel 21 ist keine Linse vorgesehen, auch nicht als gekrümmte Austrittsfläche des Strahlteilers oder als Manginspiegel.

Das System ist im Beispiel beidseitig telezentrisch.

Eine zusätzliche Lambdaviertelplatte nach dem Austritt 22 aus dem Strahlteilerprisma wie bei EP 0 608 572 A beschrieben ist auch hier möglich. Ebenso kann eine korrigierte Phasenplatte in das Objektiv eingesetzt werden oder mindestens eine Linsenfläche kann mit gleicher Wirkung asphärisch - auch nicht rotationssymmetrisch - feinbearbeitet werden.

Tabelle 2

| Beispiel aus | Tabelle 1 | US 5,402,226 Fig. 2, 3 | EP 0 608 572 Ex. 1 |
|---|---|---|---|
| $\sin R_{Reticle}$ | 0,175 | 0,145 | 0,175 |
| $\sin R_{LG1}$ | 0,180 | 0,13 | 0,116 |
| $\sin R_{LG2}$ | 0,165 | 0,06 | 0,214 |
| $\sin R_{LG3}$ | 0,341 | 0,42 | 0,315 |
| $\beta_{21}$ | 0,48 | 0,14 | 0,68 |

Dabei sind die $\sin R_X$ jeweils die Sinus des Randstrahlwinkels nach der angegebenen Gruppe x, bei $\sin R_{LG3}$ jedoch davor.

Die Angaben zu EP 0 608 572 sind mit den dortigen Objektivdaten nachgerechnet.

Im Gegensatz zum Stand der Technik wird der Randstrahlwinkel also vor dem Umlenkspiegel 6, der auch weggelassen werden kann, nicht verringert, sondern noch leicht erhöht. Die zweite Linsengruppe LG2 reduziert dann den Randstrahlwinkel im Unterschied zur EP 0 608 572, jedoch im Vergleich zum üblichen, etwa in der US 5,402,267 (wo er halbiert wird), nur geringfügig um etwa 10 %.

Von einer Kollimation am Eintritt in den polarisierenden Strahlteiler P ist die Erfindung also weit weg.

Die Gesamtbetrachtung von $\sin R_{LG2}$ und $\sin R_{LG3}$ zeigt aber, daß die Divergenzwinkelanspannung am Polarisationsstrahlteiler P insgesamt vorteilhaft niedrig ist.

Die Ausbildung der zweiten Linsengruppe LG2 ist maßgeblich für die gute Farbkorrektion dieses Objektivs.

Die chromatische Vergrößerungsdifferenz ist etwa 0,2 Promille pro Nanometer Wellenlängendifferenz. Sie ist also hervorragend klein und kompensiert in etwa die Verschiebung des Schwerpunkts durch die Farbkoma, die das entgegengesetzte Vorzeichen hat. Der dominierende Farbfehler ist der Gaußfehler - die chromatische Variation der sphärischen Aberration. Es ist möglich, diesen Fehler zu kompensieren, wenn man gezielt Farblängsfehler mit entgegengesetzten Vorzeichen einführt.

Der Gaußfehler ist eine Art Defokussierung höherer Ordnung und hat daher ähnliche Wirkung wie die FLEX-Methode (z.B. H. Fukuda et al. IEEE Trans. Electron Dev. 38 (1991), 67-75), bei der die Bildebene mehrmals bei verschiedenen Defokussierungen belichtet wird, um die Tiefenschärfe bei Einsatz kontrastverstärkender Resists zu erhöhen.

Die zulässige spektrale Bandbreite des Excimer-Lasers, die dessen Wirkungsgrad und Lichtstärke entscheidend beeinflußt, ist daher abhängig von der Prozeß-Technik des Anwenders. Sie ist aber in jedem Fall größer als 10 pm.

Dieser Wert ist besonders beachtlich, da die Dispersion von Quarz bei 193 nm fast dreimal größer ist als bei 248 nm.

Eine komplette Mikrolithographie-Projektionsbelichtungsanlage mit Excimer-Laser 44 als Lichtquelle, Beleuchtungsoptik 45, Maske 42 (auch Reticle genannt), auf einem Positioniersystem 421, mit (als erfindungsgemäßes katadioptrisches System ausgebildetem) Projektionsobjektiv 41 und (zu belichtendem) Wafer 43 auf einem Waferpositioniersystem 431 ist in Figur 2 schematisch dargestellt. Außer dem Projektionsobjektiv 41 sind die Teile und ihr Zusammenwirken gemäß dem bekannten Stand der Technik ausgebildet.

Das Projektionsobjektiv 41 gemäß der Erfindung kann abweichend vom Beispiel der Figur 1 gestaltet werden, z.B. können Abbildungsmaßstab, numerische Apertur, Bildfeld, Wellenlänge und Bandbreite bedarfsgemäß variiert werden. Dabei kann insbesondere auch eine Achromatisierung durch Verwendung verschiedener optischer Materialien ausgeführt werden. Auch bei 193 nm stehen dafür z.B. noch $CaF_2$ und LiF zur Verfügung.

**Patentansprüche**

1. Hochauflösendes lichtstarkes Objektiv mit

   - einer Objektebene (1),
   - einer ersten Linsengruppe (LG1)
   - einer zweiten Linsengruppe (LG2),
   - einem Strahlteiler (17, 18, 22, P),
   - einem Konkavspiegel (21),
   - der Systemblende (A) zwischen Strahlteiler (17, 18, 22, P) und Konkavspiegel (21) oder am Konkavspiegel (21) oder am Strahlteiler (17, 18, 22, P),
   - einer dritten Linsengruppe (LG3),
   - einer Bildebene (35) in der angegebenen Reihenfolge,
   - einem Reduktionsmaßstab ($\beta$) von -0,4 bis -0,15, vorzugsweise -0,25,
   - einer bildseitigen numerischen Apertur größer als 0,5, vorzugsweise 0,6 bis 0,75,

   wobei

   - die erste (LG1) und die zweite (LG2) Linsengruppe insgesamt

     -- den Sinus des Randstrahlwinkels reduzieren **dadurch gekennzeichnet, daß** der Sinus des Randstrahlwinkels hinter der zweiten Linsengruppe gegenüber dem Sinus vor der ersten Linsengruppe um bis zu 40% reduziert ist.

2. Objektiv nach Anspruch 1, **dadurch gekennzeichnet, daß** die zweite Linsengruppe (LG2) für sich allein den Sinus des Randstrahlwinkels um bis zu 40% reduziert.

3. Objektiv nach Anspruch 1 oder 2, **dadurch gekennzeichnet, daß** der Sinus des Randstrahlwinkels (sin $R_{LG1}$) nach der ersten Linsengruppe (LG1) nicht kleiner als der Sinus des Randstrahlwinkels (sin $R_{reticle}$) in der Objektebene (1) ist.

4. Objektiv nach mindestens einem der Ansprüche 1, 2 oder 3, **dadurch gekennzeichnet, daß** zwischen Strahlteiler (17, 18, 22, P) und Konkavspiegel (21) keine freistehende Linse angeordnet ist.

5. Objektiv nach mindestens einem der Ansprüche 1-4, **dadurch gekennzeichnet, daß** die erste (LG1) und zweite (LG2) Linsengruppe zusammen nicht mehr als sieben Linsen aufweisen.

6. Objektiv nach mindestens einem der Ansprüche 1-5, **dadurch gekennzeichnet, daß** am Strahlteiler (P) das Licht von der zweiten Linsengruppe (LG2) kommend reflektiert wird.

7. Mikrolithographie-Projektionsbelichtungsanlage mit einer Lichtquelle, die Strahlung im tiefen Ultraviolett abgibt, insbesondere einem Excimer-Laser, enthaltend ein Projektionsobjektiv mit den Merkmalen von mindestens einem der Ansprüche 1-6.

**Claims**

1. High-resolution, high-intensity objective having

   - an object plane (1),
   - a first lens group (LG1)
   - a second lens group (LG2),
   - a beam splitter (17, 18, 22, P),
   - a concave mirror (21),
   - the system diaphragm (A) between the beam splitter (17, 18, 22,) and the concave mirror (21) or on the concave mirror (21) or on the beam splitter (17, 18, 22,P),
   - a third lens group (LG3),
   - and an image plane (35), in the order indicated,

- a reduction scale (β) of from -0.4 to -0.15, preferably -0.25,
- a numerical aperture of more than 0.5 on the image side, preferably from 0.6 to 0.75,
- wherein the first lens group (LG1) and the second lens group (LG2) reduce the sine of the peripheral beam angle overall,

**characterized in that** the sine of the peripheral beam angle after the second lens group is reduced by up to 40% compared with the sine before the first lens group.

**2.** Objective according to Claim 1, **characterized in that** the second lens group (LG2) by itself reduces the sine of the peripheral beam angle by up to 40%.

**3.** Objective according to Claim 1 or 2, **characterized in that** the sine of the peripheral beam angle (sin $R_{LG1}$) after the first lens group (LG1) is not less than the sine of the peripheral beam angle (sin $R_{reticle}$) in the object plane (1).

**4.** Objective according to at least one of Claims 1, 2 and 3, **characterized in that** there are no separate lenses between the beam splitter (17, 18, 22, P) and the concave mirror (21).

**5.** Objective according to at least one of Claims 1 to 4, **characterized in that** the first lens group (LG1) and the second lens group (LG2) together have no more than seven lenses.

**6.** Objective according to at least one of Claims 1 to 5, **characterized in that** the light coming from the second lens group (LG2) is reflected at the beam splitter (P).

**7.** Microlithographic projection exposure system having a light source which emits radiation in the deep ultraviolet range, in particular an excimer laser, containing a projection objective having the features of at least one of Claims 1 to 6.

**Revendications**

**1.** Objectif lumineux à haute résolution comprenant

- un plan d'objet (1),
- un premier groupe de lentilles (LG1),
- un deuxième groupe de lentilles (LG2),
- un séparateur de faisceau (17, 18, 22, P),
- un miroir concave (21),
- l'obturateur système (A) entre le séparateur de faisceau (17, 18, 22, P) et le miroir concave (21) ou sur le miroir concave (21) ou sur le séparateur de faisceau (17, 18, 22, P),
- un troisième groupe de lentilles (LG3),
- un plan d'image (35) dans l'ordre indiqué,
- une échelle de réduction (ß) comprise entre -0,4 et -0,15, de préférence de -0,25,
- une ouverture numérique du côté de l'image supérieure à 0,5, de préférence comprise entre 0,6 et 0,75,
- le premier (LG1) et le deuxième (LG2) groupe de lentilles réduisant globalement le sinus de l'angle du rayon marginal, **caractérisé en ce que** le sinus de l'angle du rayon marginal derrière le deuxième groupe de lentilles est réduit de jusqu'à 40 % par rapport au sinus devant le premier groupe de lentilles.

**2.** Objectif selon la revendication 1, **caractérisé en ce que** le deuxième groupe de lentilles (LG2) réduit à lui seul le sinus de l'angle du rayon marginal de jusqu'à 40 %.

**3.** Objectif selon la revendication 1 ou 2, **caractérisé en ce que** le sinus de l'angle du rayon marginal (sin $R_{LG1}$) après le premier groupe de lentilles (LG1) n'est pas inférieur au sinus de l'angle du rayon marginal (sin $R_{reticle}$) dans le plan d'objet (1).

**4.** Objectif selon au moins l'une des revendications 1, 2 ou 3, **caractérisé en ce qu'**aucune lentille autonome n'est disposée entre le séparateur de faisceau (17, 18, 22, P) et le miroir concave (21).

**5.** Objectif selon au moins l'une des revendications 1 à 4, **caractérisé en ce que** le premier (LG1) et le deuxième (LG2) groupe de lentilles ne présentent ensemble pas plus de sept lentilles.

6. Objectif selon au moins l'une des revendications 1 à 5, **caractérisé en ce que** la lumière en provenance du deuxième groupe de lentilles (LG2) est réfléchie sur le séparateur de faisceau (P).

7. Équipement d'éclairage par projection microlithographique comprenant une source de lumière qui délivre un rayonnement dans l'ultraviolet profond, notamment un laser Excimer, comprenant un objectif de projection ayant les caractéristiques d'au moins l'une des revendications 1 à 6.

# FIG. 1

_FIG.2_

LASER _44_

_45_

_42_

_421_

x, y. z

_41_

_43_

x, y, z

_431_